Europäisches Patentamt

European Patent Office

Office européen des brevets

(11) Veröffentlichungsnummer: **0 179 384 B1**

(12) **EUROPÄISCHE PATENTSCHRIFT**

(45) Veröffentlichungstag der Patentschrift: **02.01.92**

(21) Anmeldenummer: **85113054.2**

(22) Anmeldetag: **15.10.85**

(51) Int. Cl.⁵: **H03K 17/945**, H03K 17/95

(54) **Störfeldfester Näherungsschalter.**

(30) Priorität: **18.10.84 DE 3438120**

(43) Veröffentlichungstag der Anmeldung:
**30.04.86 Patentblatt 86/18**

(45) Bekanntmachung des Hinweises auf die
Patenterteilung:
**02.01.92 Patentblatt 92/01**

(84) Benannte Vertragsstaaten:
**FR GB**

(56) Entgegenhaltungen:
**DE-A- 2 104 424**
**DE-A- 3 236 224**
**US-A- 3 609 527**
**US-A- 4 237 374**

(73) Patentinhaber: **Gebhard Balluff Fabrik feinme-**
**chanischer Erzeugnisse GmbH & Co.**
**Gartenstrasse 21**
**W-7303 Neuhausen a.d.F.(DE)**

(72) Erfinder: **Sommer, Gerhard, Dipl.-Ing.**
**Wielandstrasse 5**
**W-7441 Kohlberg(DE)**

(74) Vertreter: **Hoeger, Stellrecht & Partner**
**Uhlandstrasse 14 c**
**W-7000 Stuttgart 1(DE)**

## Beschreibung

Die Erfindung betrifft einen Näherungsschalter zum Positionsnachweis eines Maschinenelements mit mindestens zwei auf dieses Maschinenelement ansprechenden und dabei ihre elektrischen Größen verändernden Sensoren, die durch elektrische und/oder magnetische Störfelder beeinflußbar sind, die in einem derartigen Abstand voneinander angeordnet sind, daß einer der Sensoren von dem Maschinenelement in seiner zu detektierenden Stellung einen kleineren Abstand aufweist als der andere, und die zur Bildung eines Differenzsignals aus den jeweiligen elektrischen Größen der Sensoren mit einer Differenzschaltung verbunden sind, um gleiche durch die Störfelder erzeugte Signale zu kompensieren.

Aus der US-PS 3 609 527 ist ein derartiger Näherungsschalter bekannt. Das Grundprinzip der in dieser Druckschrift offenbarten Schaltung besteht darin, daß durch einen Oszillator und eine mit diesem verbundene Spule zwei weitere Spulen über Induktion angeregt werden.

Um eine derartige und vor allem gleichmäßige Anregung der beiden weiteren Spulen zu erreichen, müssen diese gemeinsam mit der mit dem Oszillator verbundenen Spule auf einem Spulenkörper und in gleichen Abständen voneinander angeordnet sein, so daß alle Spulen räumlich gesehen eine einzige Spule bilden und somit auch alle Spulen miteinander magnetisch gekoppelt sind.

Ausgehend von dieser Anordnung führt nun eine Störung des Magnetfeldes in einer der weiteren Spulen durch Annähern eines leitfähigen Körpers zu einem Ungleichgewicht in einer nachfolgenden Brückenschaltung und somit zu einem Signal.

Darüberhinaus offenbart diese Druckschrift ebenfalls noch, daß in Feldern mit starker elektromagnetischer Interferenz in den beiden weiteren Spulen dieselben Effekte auftreten und sich somit diese Effekte aufgrund der nachgeschalteten Differenzschaltung kompensieren.

Der Erfindung liegt die Aufgabe zugrunde, einen Näherungsschalter der gattungsgemäßen Art derart zu verbessern, daß dieser die Annäherung des Maschinenelements über ein Magnetfeld detektieren kann und außerdem dessen Funktion nicht durch magnetische und/oder elektrische Störfelder beeinflußbar ist und somit trotz dieser Störfelder keine Fehlschaltungen ausgelöst werden.

Diese Aufgabe wird bei einem Näherungsschalter der eingangs beschriebenen Art erfindungsgemäß dadurch gelöst, daß das Maschinenelement mit einem Magnet versehen ist, daß die Sensoren als auf den an dem Maschinenelement gehaltenen Magneten ansprechende Magnetfeldsensoren ausgebildet sind, daß zur Elimination von Störfeldern mit Störfeldgradienten die beiden Sensoren relativ zu dem Magnet in der zu detektierenden Stellung des Maschinenelements so in dem Magnetfeld desselben angeordnet sind und einen derartigen Abstand voneinander besitzen, daß ein möglichst großer Feldgradient des Magneten in Richtung des Abstandes der Sensoren vorliegt und das durch den Magneten in seiner zu detektierenden Stellung erzeugte Differenzsignal größer ist als das durch die Störfelder aufgrund ihres Störfeldgradienten erzeugte Differenzsignal und daß der Näherungsschalter mit einem den Sensoren zugeordneten Schaltkreis zum Umsetzen der veränderlichen elektrischen Größen der Sensoren in Ausgangssignale des Näherungsschalters versehen ist, welcher das die zu detektierende Stellung des Maschinenelements anzeigende Ausgangssignal nur bei Auftreten des durch den Magneten erzeugte Differenzsignals abgibt.

Besonders vorteilhaft einsetzbar sind die erfindungsgemäßen Näherungsschalter an Pneumatikzylindern zum Positionsnachweis der Kolben, da diese Kolben serienmäßig mit kleinen Magneten ausgestattet sind, welche ihrerseits auf außen am Pneumatikzylinder montierte Näherungsschalter wirken und somit einen Positionsnachweis des Kolbens in dem Zylinder ermöglichen.

Der Vorteil der erfindungsgemäßen Näherungsschalter besteht darin, daß durch Bildung eines Differenzsignals magnetische und/oder elektrische Störfelder kompensierbar sind, so daß die Störfelder, die die beiden Sensoren in gleicher Weise beeinflußen, eliminiert werden und somit der Näherungsschalter in Abwesenheit und in Gegenwart dieser Störfelder mit der gleichen Zuverlässigkeit funktioniert. Damit entfallen sämtliche der obengenannten Nachteile der bisher bekannten Näherungsschalter, so daß beispielsweise die Steuerung von Pneumatikzylindern und gleichzeitig ein Positionsnachweis der Kolben dieser Zylinder über die erfindungsgemäßen Näherungsschalter während laufender Schweißvorgänge erfolgen kann, ohne daß durch diese Näherungsschalter Fehlschaltungen ausgelöst werden.

Aufgrund der Tatsache, daß das Maschinenelement in dem im näherstehenden Sensor ein weitaus größeres Signal auslöst als in dem von ihm fernliegenden Sensor und somit ein Gradient der Wirkung des Maschinenelements über dem Abstand der beiden Sensoren vorliegt, besteht ein weiterer wesentlicher Vorteil des erfindungsgemäßen Näherungsschalters darin, daß bei diesem nicht nur räumlich konstante Störfelder, sondern auch Störfelder, die einen räumlichen Gradienten besitzen, kompensiert werden können, solange das von dem Maschinenelement ausgelöste Differenzsignal größer als das von dem Störfeld ausgelöste Differenzsignal ist. Dies ist bedeutsam für die praktischen Anwendungen, da z.B. ein stromführendes Kabel ein Magnetfeld erzeugt, dessen Feldstärke in Abhängigkeit des Abstandes von dem Kabel einen Gradienten besitzt. Aber selbst ein solches dicht neben einem Näherungsschalter vorbeiführendes Kabel veranlaßt diesen nicht zum Auslösen von Störsignalen solange das erzeugte Differenzsignal kleiner als das durch das Maschinenelement erzeugte Differenzsignal ist.

Wenn jedoch die elektronische Schaltung zum Verarbeiten der von den Sensoren erzeugten Signale möglichst einfach sein soll, was vor allem im Hinblick auf kostengünstige Ausführungsformen der Näherungsschalter bedeutsam ist, ist bei derartigen Lösungen vorgesehen, daß die beiden Sensoren relativ zu dem Maschinenelement so angeordnet sind und einen derartigen Abstand voneinander besitzen, daß das aufgrund des Maschinenelements in seiner zu detektierenden Stellung erzeugte Differenzsignal mindestens ungefähr um einen Faktor 10 größer ist als das durch die Störfelder erzeugte Differenzsignal. Damit kann die Meldung, daß das Maschinenelement in seiner zu detektierenden Stellung steht, in einfacher Weise durch Über- bzw. Unterschreiten eines vorherbestimmbaren Signalpegels, ausgelöst durch das seine zu detektierende Stellung erreichende Maschinenelement, erfolgen wobei die um einen Faktor 10 geringere Unsicherheit, verursacht durch eventuell vorhandene Störfelder mit einem räumlichen Gradient unerheblich ist. Selbstverständlich können mit dem erfindungsgemäßen Näherungsschalter auch Störfelder detektiert werden, die einen wesentlich größeren Gradienten besitzen, wenn größere Ungenauigkeiten beim Schalten, d.h. Nachweis des Maschinenelements in seiner zu detektierenden Stellung, in Kauf genommen werden oder wenn die elektronische Schaltung zum Verarbeiten der Differenzsignale aufwendiger ausgelegt ist und geringere Unterschiede zwischen dem durch das Maschinenelement ausgelösten Differenzsignal und dem durch die Störfelder ausgelösten Differenzsignal feststellen kann.

Vor allem in solchen Anwendungsfällen, in denen ein Verlauf der Feldlinien des Magnetfeldes in der zu detektierenden Stellung des Maschinenelements bekannt ist, wird ein sichereres und besseres Schaltverhalten des Näherungsschalters erreicht, wenn die Magnetfeldsensoren eine Vorzugsrichtung besitzen und so ausgerichtet sind, daß diese parallel zu einem nachzuweisenden Magnetfeld verläuft. Eine derartige Anordnung der Magnetfeldsensoren verstärkt nicht nur das durch das Maschinenelement erzeugte Differenzsignal, sondern führt im allgemeinen auch dazu, daß das durch einen Feldgradienten des Störfeldes erzeugte Differenzsignal im Verhältnis zu dem durch das Maschinenelement erzeugten unterdrückt ist.

Bei einem sehr einfachen und auch zuverlässigen Ausführungsbeispiel des erfindungsgemäßen Näherungsschalters sind die Magnetfeldsensoren aus einem Material hergestellt, das seinen elektrischen Widerstand in Abhängigkeit von dem äußeren Magnetfeld ändert. In diesem Fall sind die Sensoren somit nur durch magnetische Felder beeinflußbar, so daß auch nur magnetische Störfelder ein Differenzsignal erzeugen können.

Ein anderes Ausführungsbeispiel eines magnetfeldempfindlichen Näherungsschalter sieht vor, daß die Sensoren Hall-Sensoren sind. Bei diesen sind als Störfelder nicht nur magnetische Felder in Betracht zu ziehen, sondern es können auch elektrische Felder auf die erzeugte Hall-Spannung einen Einfluß haben.

Bei einer besonders bevorzugten Ausführungsform der magnetfeldempfindlichen Näherungsschalter ist vorgesehen, daß den Magnetfeldsensoren räumlich in unmittelbarer Nähe ein Verstärker zugeordnet ist, der die hochohmigen Signale in niederohmige umsetzt, die dann der Differenzschaltung zugeleitet werden. Diese Maßnahme führt zu einer erheblichen Reduzierung der Störanfälligkeit der Schaltung hinsichtlich elektromagnetischer Einstreuungen, da diesbezüglich nur der hochohmige Teil der Schaltung empfindlich ist.

Wie aus den vorstehenden Ausführungen zu entnehmen ist, stellen die magnetfeldempfindlichen Näherungsschalter nur eine besondere Form der erfindungsgemässen Näherungsschalter dar. So ist bei einer weiteren Variante der erfindungsgemässen Näherungsschalter vorgesehen, dass als Sensoren Spulen von Schwingkreisen von Oszillatoren dienen, die jeweils durch Annähern eines metallischen Maschinenelements an die Spule bedämpfbar sind. Diese Näherungsschalter erfordern somit nicht, dass das Schienenelement selbst ein Feld erzeugt, das durch den Sensor detektierbar ist, sondern reagieren ganz allgemein auf Metall, da das Annähern eines Metalles an die Spule eines Schwingkreises zu dessen Bedämpfung führt. Für diese Näherungsschalter bieten sich weit grössere Einsatzmöglichkeiten als für die magnetfeldempfindlichen, da diese zum Positionsnachweis jedes metallischen Körpers einsetzbar sind, ohne dass dieser weitere Bedingungen erfüllen muss.

Die Erfindung betrifft somit ferner auch einen Näherungsschalter zum Positionsnachweis eines metallischen Maschinenelements mit mindestens zwei als Spulen mindestens einer Oszillatorschaltung ausgebildeten und durch Annäherung des Maschinenelements bedämpfbaren und dabei ihre elektrischen Größen verändernden Sensoren, die durch magnetische Störfelder beeinflußbar sind, die in einem derartigen Abstand voneinander angeordnet sind, daß einer der Sensoren von dem Maschinenelement in seiner zu detektierenden Stellung einen kleineren Abstand aufweist als der andere, und die zur Erzeugung eines Differenzsignals aus den jeweiligen elektrischen Größen der Sensoren miteinander verbunden sind, um die durch die Störfelder erzeugten Signale zu kompensieren und mit einem den Sensoren zugeordneten Schaltkreis zum Umsetzen des Differenzsignals in Ausgangssignale des Näherungsschalters.

Ebenfalls ausgehend von der US-PS 3,609,527 liegt der Erfindung die Aufgabe zugrunde, einen Näherungsschalter der vorstehend genannten Art derart zu verbessern, daß dieser die Annäherung eines Spulen von Schwingkreisen bedämpfenden Maschinenelements detektieren kann und außerdem dessen Funktion nicht durch magnetische Störfelder beeinflußbar ist und somit trotz dieser Störfelder keine Fehlschaltungen ausgelöst werden.

Diese Aufgabe wird bei einem Näherungsschalter der vorstehend genannten Art erfindungsgemäß dadurch gelöst, daß jeder Spule ein eigener Oszillator und jeder Spule mit eigenem Oszillator eine eigene Gleichrichterschaltung zugeordnet ist, welch letztere an dem zugeordneten Oszillator abgegriffene Spannungen gleichrichtet und einen Mittelwert bildet sowie diesen Mittelwert einer Differenzschaltung zur Erzeugung des Differenzsignals übermittelt, daß die beiden Sensoren relativ zu dem Maschinenelement so angeordnet sind und einen derartigen Abstand voneinander besitzen, daß ein möglichst großer Gradient der Bedämpfung in Richtung des Abstandes der Sensoren vorliegt und das aufgrund des Maschinenelements in seiner zu detektierenden Stellung erzeugte Differenzsignal größer ist als das durch die Störfelder erzeugte Differenzsignal und daß der Näherungsschalter mit einem den Sensoren zugeordneten Schaltkreis zum Umsetzen der veränderlichen elektrischen Größen der Sensoren in Ausgangssignale des Näherungsschalters versehen ist, welcher das die zu detektierende Stellung des Maschinenelements anzeigende Ausgangssignal nur bei Auftreten des durch das Maschinenelement erzeugten Differenzsignals abgibt.

Ein großer Vorteil dieses erfindungsgemäßen Näherungsschalters zeigt sich darin, daß bei den bisher bekannten Lösungen sehr große Temperaturdriften auftreten, während durch das Vorsehen zweier separater Oszillatoren mit jeweils separaten Spulen und jeweils separater Gleichrichtung die Temperaturschwankungen in erheblichem Maße ausgeglichen werden können, so daß der erfindungsgemäße Näherungsschalter neben seiner Störfeldfestigkeit auch noch einen wesentlich größeren Schaltabstand ermöglicht, da die temperaturbedingten Schwankungen in den Spannungsamplituden der Oszillatoren kompensiert werden können. Folglich reicht eine wesentlich geringere Bedämpfung einer Spule mit Oszillator durch das Maschinenelement aus, um zuverlässig das Schaltsignal auszulösen.

Ferner werden durch die erfindungsgemäße Lösung mit zwei Spulen, zwei Oszillatoren und zwei Gleichrichtern all die Probleme vermieden, die dann auftreten, wenn man eine direkte Differenzbildung der Spannungsamplituden der Oszillatoren vornimmt, da in diesem Fall die Frequenzen der beiden Resonatoren exakt gleich sein und gleich gehalten werden müssen, um das Auftreten von Schwebungen und ähnlichen Defekten zu vermeiden.

Es ist bei derartigen induktiven Näherungsschaltern denkbar, mit Luftspulen zu arbeiten. In diesen Fällen führt ein zeitabhängiges, magnetisches Störfeld, beispielsweise ein Schweißfeld, das mit 50 Hz oszilliert, zur Induktion einer Spannung in der Spule, die sich mit der Spannung des Oszillators überlagert und zu einer Fehlanzeige des Näherungsschalters führt. Durch die erfindungsgemäße Anordnung zweier Spulen im Abstand voneinander werden jedoch in beiden Spulen dieselben Spannungen induziert, die anschließend durch Bildung eines Differenzsignals wieder eliminiert werden, so daß das zeitabhängige magnetische Störfeld ohne Einfluß bleibt.

Im allgemeinen sind jedoch die bei derartigen Näherungsschaltern als Sensoren verwendeten Spulen mit Ferritkernen versehen. Sobald sich nun die Sensoren in einem äußeren Störmagnetfeld befinden, führt das Störmagnetfeld zu einer Sättigung dieser Ferritkerne, die genau wie das Annähern eines Maschinenelements an einen derartigen Sensor eine Bedämpfung des dazugehörigen Oszillators zur Folge hat. Obwohl letztendlich sowohl durch Annähern eines metallischen Maschinenelements an den Sensor als auch durch Auftreten eines äußeren magnetischen Störfelds jeweils der Oszillator des Schwingkreises bedämpft wird, liegen diesen beiden Effekten vollkommen unterschiedliche Mechanismen zugrunde. Bei Annähern des Maschinenelements wird das von dem Ferritkern der Spule ausgehende Feld beeinflußt, wohingegen durch ein äußeres Magnetfeld der Ferritkern vormagnetisiert und somit näher bei seinem Sättigungsbereich ist, so daß er folglich als Feldkonzentrator für die Spule wesentlich weniger wirksam ist. Die Differenzbildung führt bei einer derartigen Ausgestaltung des Näherungsschalters dazu, daß die Bedämpfung beider Oszillatoren durch das magnetische Störfeld kein Ausgangssignal auslösen kann, sondern eliminiert wird.

Zur Steigerung der Empfindlichkeit, vor allem der dem Maschinenelement am nächsten liegenden Spule, ist es vorteilhaft, wenn die Spulen mit Topfkernen versehen sind, so daß sich das Magnetfeld dieser Spule im wesentlichen nur auf einer Seite von dieser ausbreitet. In dieses Feld tritt dann das Maschinenelement ein und führt zu einer Bedämpfung des der Spule zugeordneten Oszillators.

Da sich die Oszillatoren durch die im Abstand zueinander in dem Näherungsschalter angeordneten Spulen, d.h. durch die Überlagerung der von den Spulen ausgehenden Magnetfelder, gegenseitig beeinflussen, ist es günstig, wenn zwischen den Spulen eine Abschirmung vorgesehen ist, die dieses verhindert, so daß keine störenden Schwebungen und ähnliche Wechselwirkungen der Oszillatoren auftreten, die zu Fehlschaltungen des Näherungsschalters führen würden.

Desweiteren ist es zweckmäßig, wenn die Spulen identisch ausgebildet sind, wobei es in diesem Fall zusätzlich vorteilhaft ist, wenn die Spulen koaxial zueinander angeordnet sind. Auch diese Anordnung vermindert die gegenseitige Überlagerung der Magnetfelder der Spulen und somit die gegenseitige Beeinflussung der Oszillatoren.

Die Merkmale und Vorteile der Erfindung ergeben sich auch aus der folgenden Beschreibung sowie der beigefügten zeichnerischen Darstellung einiger Ausführungsformen der Erfindung. In der Zeichnung zeigen:

Fig. 1 einen aufgebrochenen, magnetfeldempfindlichen Näherungsschalter in einem magnetischen Störfeld eines Kabels sowie ein zu detektierendes Maschinenelement;

Fig. 2 eine Schaltungsskizze des Näherungsschalters in Fig. 1;

Fig. 3 eine schematische Darstellung einer räumlichen Anordnung von Magnet, Sensoren und Kabel sowie einer dieser Anordnung entsprechenden räumlichen Abnahme von Magnetfeld und Störfeld;

Fig. 4 einen aufgebrochenen induktiven Näherungsschalter im magnetischen Störfeld eines Kabels sowie ein zu detektierendes Maschinenelement;

Fig. 5 ein Blockschaltbild des Näherungsschalters in Fig. 4 und

Fig. 6 eine schematische Darstellung von Änderungen eines Signalpegels der Oszillatoren und eines Differenzsignals bei unterschiedlicher Bedämpfung.

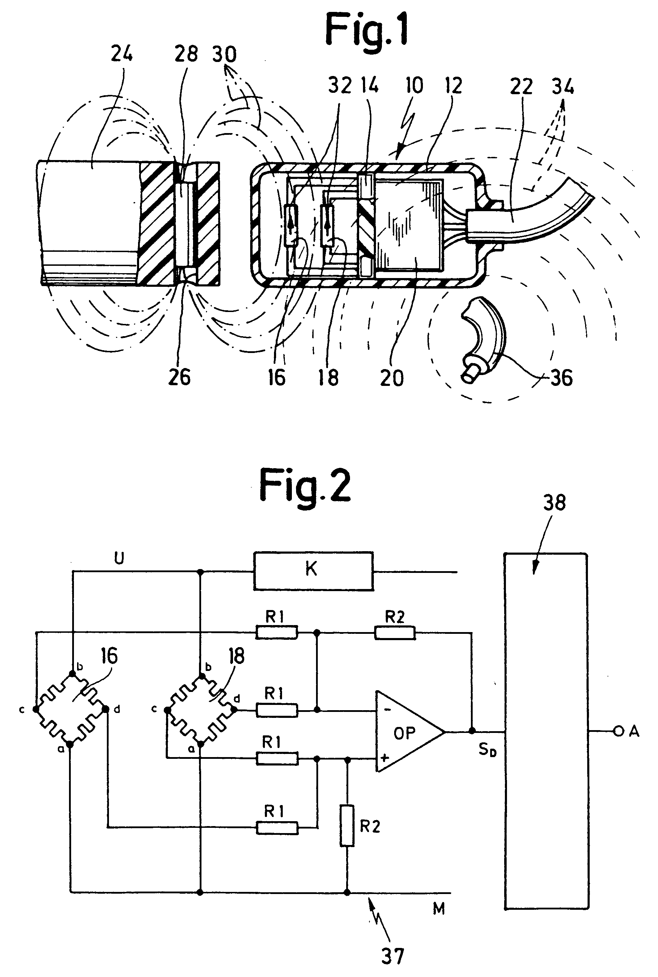

Fig. 1 zeigt im einzelnen ein Gehäuse 12 eines als Ganzes mit 10 bezeichneten magnetfeldempfindlichen Näherungsschalters. Innerhalb dieses Gehäuses 12 ist eine Trägerplatte 14 vorgesehen, auf deren einer Seite zwei identische Magnetfeldsensoren 16 und 18 gehalten sind, die ihrerseits in Richtung einer auf dieser Seite der Trägerplatte 14 stehenden Flächennormalen einen Abstand voneinander aufweisen. Auf einer den Magnetfeldsensoren 16 und 18 gegenüberliegenden Seite der Trägerplatte 14 schliesst sich eine als Ganzes mit 20 bezeichnete elektrische Schaltung an, welche mit den beiden Magnetfeldsensoren 16 und 18 in Verbindung steht und eine Differenzschaltung sowie einen an sich bei derartigen Näherungsschaltern bekannten Schaltkreis zur Erzeugung von Ausgangssignalen umfasst. Eine Spannungsversorgung der Schaltung 20 sowie eine Abnahme der Ausgangssignale erfolgt über ein Zuleitungskabel 22, das den Näherungsschalter 10 beispielsweise mit einer Steuerung verbindet.

Ein durch den Näherungsschalter 10 zu detektierendes Maschinenelement 24 ist mit einer Bohrung 26 versehen, in welcher ein Stabmagnet 28 gehalten ist, welcher ein Magnetfeld 30 erzeugt.

Jeder der Magnetfeldsensoren besitzt eine Vorzugsrichtung 32, die von der Art des jeweiligen Sensors abhängig ist. Bevorzugterweise sind die Magnetfeldsensoren 16, 18 relativ zueinander so angeordnet, dass die Vorzugsrichtungen 32 parallel zueinander stehen und die Magnetfeldsensoren eine gemeinsame Mittelebene besitzen, die senkrecht zu der jeweiligen Vorzugsrichtung 32 verläuft. Die Anordnung bezüglich der Trägerplatte 14 ist vorteilhafterweise so gewählt, dass die Vorzugsrichtungen 32 parallel zu dieser ausgerichtet sind.

Der Näherungsschalter 10 ist relativ zu Feldlinien des Magnetfelds 30 so anzuordnen, dass diese parallel zu den Vorzugsrichtungen 32 der Magnetfeldsensoren 16 und 18 verlaufen und ebenfalls die Magnetfeldsensoren 16 und 18 durchdringen. Selbstverständlich ist für eine einwandfreie Funktion des Näherungsschalters Voraussetzung, dass das Gehäuse 12 zumindest in einem die Magnetfeldsensoren 16 und 18 umgebenden Teilbereich für das Magnetfeld 30 durchlässig ist.

Ein magnetisches Störfeld 34 entsteht durch ein in der Umgebung des Näherungsschalters 10 verlaufendes Kabel 36, das beispielsweise, wie in Fig. 1 dargestellt, unterhalb dieses Näherungsschalters 10 verläuft. Dabei durchdringt das Störfeld 34 ebenfalls die Magnetfeldsensoren 16 und 18, so dass diese zusätzlich zu dem Einfluss des Magnetfelds 30 auch noch unter dem des Störfelds 34 stehen.

Die Schaltskizze in Fig. 2 zeigt die beiden Magnetfeldsensoren 16 und 18, die jeweils vier als Wheatstonebrücke zusammengeschaltete Widerstände aus Permalloy umfassen. Diese Widerstände sind im allgemeinen als mäanderförmige Schichten auf einem gemeinsamen Trägersubstrat, beispielsweise einem Silizium-Chip, aufgedampft. Hierbei handelt es sich um handelsübliche Permalloy-Sensoren, die z.B. über die Firmen Valvo, Sony oder Siemens bezogen werden können. Jeder der Sensoren besitzt vier Anschlüsse a, b, c, d, wobei die Anschlüsse a und b sowie c und d jeweils einander gegenüberliegenden Abgriffen der Wheatstonebrücke entsprechen.

Die von einem Konstantspannungsregler K gelieferte Spannung U liegt jeweils an den Anschlüssen b der Magnetfeldsensoren 16 und 18 an, wohingegen die Anschlüsse a dieser Magnetfeldsensoren 16, 18 auf Masse M liegen. Die einander gegenüberliegenden Mittelabgriffe c und d der Wheatstonebrückenschaltung eines jeden Magnetfeldsensors 16 und 18 sind so mit den beiden Eingängen eines Operationsverstärkers OP verbunden, dass beispielsweise der Anschluss c des Magnetfeldsensors 18 und der Anschluss d des Magnetfeldsensors 16 mit einen mit + gekennzeichneten, nicht invertierenden Eingang des Operationsverstärkers OP und die Anschlüsse d des Magnetfeldsensors 18 sowie c des Magnetfeldsensors 16 mit einem invertierenden Eingang des Operationsverstärkers OP verbunden sind. Jeweils zwischen den Anschlüssen c und d der Magnetfeldsensoren 16 und 18 und den Eingängen des Operationsverstärkers OP liegende Widerstände R1 dienen zusammen mit den Widerständen R2, von denen einer zwischen den nichtinvertierenden Eingang und Masse und der andere zwischen dem invertierenden Eingang und dem Ausgang des Operationsverstärkers OP liegt, zur üblichen Einstellung des Arbeitspunktes und der Verstärkung des Operationsverstärkers OP. Ein Ausgangssignal $S_D$ des Operationsverstärkers OP wird über eine nur als Block 38 angedeutete Schaltung in ein Ausgangssignal A umgesetzt. Der Block 38 enthält die für bisher bekannte Magnetfeldschalter üblichen Komponenten, wie z.B. einen Tiefpass, eine Kippstufe für positives Feld, eine Kippstufe für negatives Feld, sofern erforderlich eine Impulshaltungsstufe und schliesslich eine Leistungsstufe mit Funktionsanzeige, welche das Ausgangssignal A liefert.

Diese Gegeneinanderschaltung der Magnetfeldsensoren 16 und 18 hat zur Folge, dass der Operationsverstärker OP nicht nur als Verstärker, sondern gleichzeitig als Differenzschaltung 37 arbeitet und die aufgrund eines Magnetfelds erfolgten Widerstandsänderungen in den Magnetfeldsensoren 16 und 18 voneinander subtrahiert. So führt beispielsweise ein Magnetfeld, welches das Potential am Anschluss d anhebt und das Potential am Anschluss c absenkt, zu keinen Änderungen der Potentiale an den beiden Eingängen des Operationsverstärkers OP, wenn bei beiden Magnetfeldsensoren die Potentialänderungen gleichgross sind, da jeweils die Anhebung des Potentials am Anschluss d des einen Magnetfeldsensors durch die Absenkung des Potentials am Anschluss c des anderen Magnetfeldsensors kompensiert wird. Erst eine unterschiedliche Anhebung oder Absenkung der Potentiale bei c und d der beiden Magnetfeldsensoren 16 und 18 führt zu einer Veränderung der Potentiale an den beiden Eingängen des Operationsverstärkers, so dass dieser ein Differenzsignal $S_D$ liefert, das durch die Schaltung im Block 38 in das Ausgangssignal A umgesetzt wird.

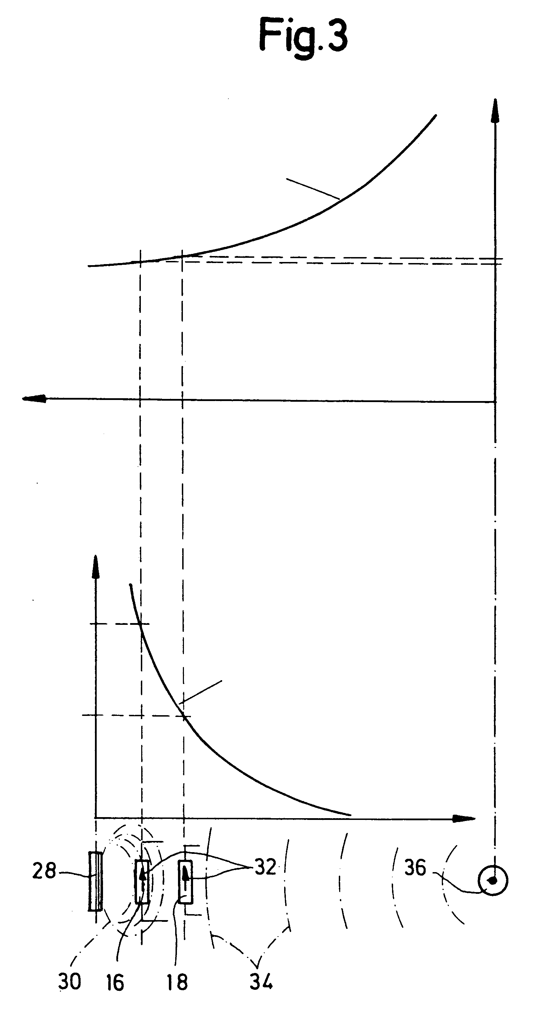

Die Arbeitsweise des in den Fig. 1 und 2 beschriebenen Näherungsschalters wird an Hand der schematischen Darstellung in Fig. 3 erläutert. Die Lage des Stabmagneten 28 relativ zu den Magnetfeldsensoren 16 und 18 sowie zum Kabel 36 sind für diesen Fall skizziert, wobei in der anschaulichsten geometrischen Anordnung eine Achse des Stabmagneten 28 in der Zeichenebene liegt und parallel zu den ebenfalls in der Zeichenebene liegenden Vorzugsrichtungen 32 der Magnetfeldsensoren 16 und 18 weist. Das auf der dem Stabmagnet 28 gegenüberliegenden Seite der Magnetfeldsensoren 16, 18 und im Abstand von diesen angeordnete Kabel 36 verläuft senkrecht zur Zeichenebene in einer senkrecht zu den Vorzugsrichtungen 32 stehenden Mittelebene der Magnetfeldsensoren 16, 18. Wie Fig. 3 zeigt, verlaufen bei dieser Anordnung die Feldlinien des Stabmagneten 28 sowie des stromdurchflossenen Kabels 36 am Ort der Magnetfeldsensoren 16 und 18 parallel zueinander und ebenfalls parallel zu deren Vorzugsrichtungen 32.

Das obere Diagramm zeigt den charakteristischen Abfall der Feldstärke des magnetischen Störfeldes 34 in Abhängigkeit eines radialen Abstandes von dem Strom durchflossenen Kabel 36. Wie aus den Schnittpunkten der beiden gestrichelten Linien, die jeweils den Ort der Magnetfeldsensoren 16 und 18 im Abstand von dem Kabel 36 angeben, mit dem Feldstärkeverlauf des Störfeldes 34 zu ersehen ist, liegt am Ort des Magnetfeldsensors 18 nur eine geringfügig höhere Störfeldstärke vor als am Ort des Magnetfeldsensors 16.

Das untere Diagramm in Fig. 3 zeigt die Feldstärke des Magnetfeldes 30 in einer Richtung senkrecht zur Achse des Stabmagneten 28 in Abhängigkeit vom Abstand von diesem. Die Schnittpunkte der diesen Feldverlauf anzeigenden Kurve mit den gestrichelten Linien, die den Ort der Magnetfeldsensoren 16 und 18 angeben, zeigen, dass in diesem Falle am Ort des Magnetfeldsensors 16 ein grösseres Feld vorliegt als am Ort des Magnetfeldsensors 18. Entscheidend ist jedoch, dass die Schaltung gemäss Fig. 2 mit den Magnetfeldsensoren 16 und 18 keine absoluten Werte des Magnetfeldes misst, sondern sofort die Differenz dieser beiden Felder bildet, so dass nur jeweils die Differenz der an den Magnetfeldsensoren 16 und 18 vorherrschenden Magnetfelder erheblich ist. Aus diesem Grund ist auch der Absolutwert der Feldstärke des Störfeldes 34, der gemäss Fig. 3 in derselben Grössensordnung liegt wie die Feldstärke des Magnetfeldes 30, bedeutungslos, da das Störfeld 34 am Ort der beiden Magnetfeldsensoren 16 und 18 nur eine gering unterschiedliche Feldstärke besitzt. Das Störfeld 34 ist somit nur ein im wesentlichen konstantes, dem Magnetfeld 30 überlagertes Feld am Ort beider Sensoren, das aufgrund der Differenzbildung weitgehend eliminiert wird.

Damit eine möglichst optimale Unterdrückung des Störfeldes erreicht wird, werden die beiden Magnetfeldsensoren 16 und 18 möglichst nahe der zu detektierenden Stellung des Maschinenelements 24 so angeordnet, dass sie sich in einem Bereich des Magnetfeldes 30 befinden, in dem ein möglichst grosser Gradient in Richtung des Abstandes der beiden Magnetfeldsensoren 16 und 18 vorliegt. Dieser Feldgradient des Magnetfeldes 30 erlaubt, die beiden Magnetfeldsensoren 16 und 18 mit möglichst geringem Abstand relativ zueinander anzuordnen, und ergibt trotzdem noch ein nennenswertes Differenzsignal. Der Vorteil besteht nun darin, dass einerseits die beiden Magnetfeldsensoren dann in der Regel relativ weit entfernt vom Zentrum des Störfeldes liegen und andererseits in einem Bereich des Feldstärkeverlaufs, in dem dieser in Richtung des Abstandes der Magnetfeldsensoren 16, 18 nur noch einen sehr geringen Gradient aufweist, wobei noch der geringe Abstand der beiden Magnetfeldsensoren 16 und 18 hinzukommt, so dass auch die Unterschiede in den Feldstärken des Störfeldes 34 am Ort der Magnetfeldsensoren 16 und 18 sehr gering sind und folglich das durch das Störfeld 34 bedingte Differenzsignal wesentlich kleiner als das Differenzsignal aufgrund des Magnetfeldes 30 ist. D.h. allgemein formuliert, dass die beiden Magnetfeldsensoren 16 und 18 in einem Feldbereich des Magnetfeldes 30 angeordnet werden sollten, in welchem ein möglichst grosser Gradient dieses Feldes vorherrscht, so dass sie zur Erzeugung eines ausreichenden Differenzsignals möglichst dicht beieinander liegen können und folglich auch die Unterdrückung des magnetischen Störfeldes 34 optimal ist.

Die in den Fig. 1 und 3 dargestellte Anordnung der beiden Magnetfeldsensoren 16 und 18 geht davon aus, dass die jeweiligen Vorzugsrichtungen 32 der beiden parallel zueinander verlaufen. Es ist jedoch innerhalb des Rahmens der vorliegenden Erfindung durchaus denkbar, dass beispielsweise die Vorzugsrichtung 32 des Magnetfeldsensors 16 parallel zu dem am Ort des Magnetfeldsensors 16 vorherrschenden Magnetfeld 30 verläuft und dass die Vorzugsrichtung 32 des Magnetfeldsensors 18 gegenüber der Richtung des an seinem Ort vorherrschenden Magnetfeldes 30 geneigt ist, so dass das Magnetfeld 30 ein grösseres Differenzsignal $S_D$ hervorruft als bei Magnetfeldsensoren 16 und 18 mit parallel zueinander ausgerichteten Vorzugsrichtungen. Diese Anordnung wäre in bestimmten Fällen zum Erzeugen eines grösseren Differenzsignals $S_D$ vorteilhaft, sie hat jedoch den Nachteil, dass eine Ausrichtung des Störfeldes 34, bei welcher dieses am Ort des Magnetfeldsensors 18 parallel zu dessen Vorzugsrichtung 32 verläuft und folglich am Ort des Magnetfeldsensors 16 nicht parallel zu dessen Vorzugsrichtung 32 liegt, ebenfalls ein grösseres Differenzsignal $S_D$ hervorruft, so dass insgesamt keine bessere Störfeldunterdrückung erreichbar ist. Aus diesem Grund ist es bei in Grosserien hergestellten, universell einsetzbaren Näherungsschaltern günstig, wenn die Vorzugsrichtungen 32 der beiden Magnetfeldsensoren 16 und 18 parallel zueinander liegen.

Des weiteren können die Permalloy-Sensoren, in dem in den Fig. 1 bis 3 beschriebenen Ausführungsbeispiel auch durch Hallsensoren ersetzt werden, die wie die Permalloy-Sensoren magnetfeldempfindlich sind. Derartige handelsübliche Hallsensoren können beispielsweise von den Firmen Honeywell, Sprague und Siemens bezogen werden. Auch die Hallsensoren zeigen eine Vorzugsrichtung, so dass prinzipiell die Anordnung in den Fig. 1 und 3 in identischer Weise erfolgen kann. Ausserdem können auch die Hallsensoren anstelle der Wheatstone-Brücke in die Schaltskizze in Fig. 2 eingesetzt werden, wobei der Konstantspannungsregler K für einen konstanten Strom über den Hallsensor sorgt und die jeweils an den beiden Hallsensoren abgegriffene Hallspannungen gegeneinander geschaltet, wie bei den beiden Wheatstone-Brücken in Fig. 2, mit den Eingängen des Operationsverstärkers OP zu verbinden sind. Selbstverständlich sind dann die Konstantspannung U sowie die Widerstände R1 und R2 den jeweiligen Spezifikationen der Hallsensoren und des verwendeten Operationsverstärkers OP anzupassen.

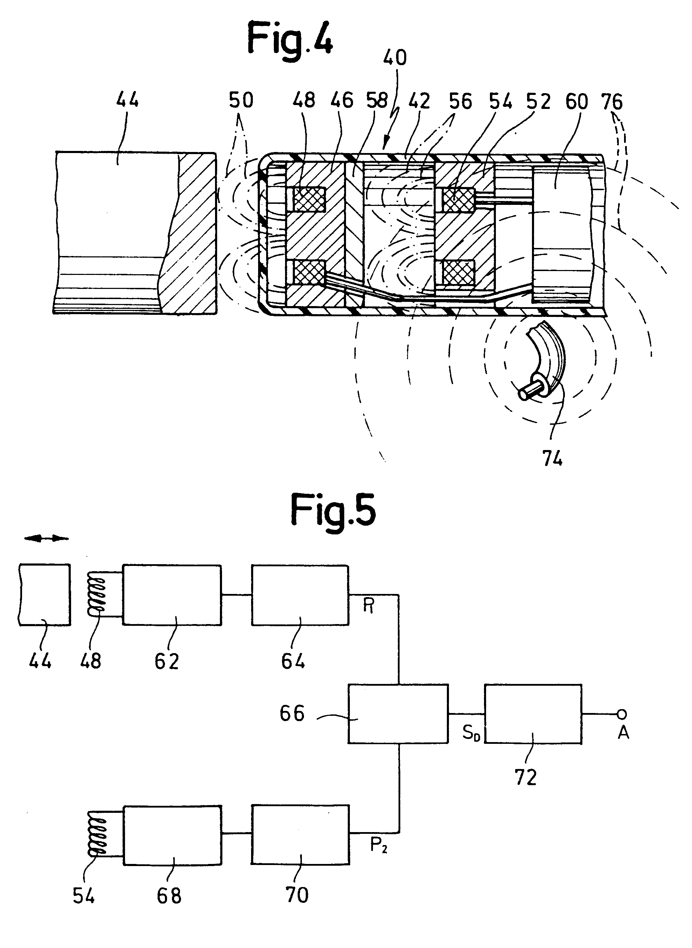

Das zweite Ausführungsbeispiel eines erfindungsgemässen Näherungsschalters zeigt Fig. 4. Dieser basiert auf dem Prinzip eines bisher bereits bekannten induktiven Näherungsschalters. Der als Ganzes mit 40 bezeichnete Näherungsschalter besitzt ein Gehäuse 42, in welchem in einem einem zu detektierenden Maschinenelement 44 zugewandten Bereich ein Topfkern 46 mit einer darin gelagerten Spule 48 gehalten ist. Der Topfkern 46 ist dabei so ausgerichtet, dass diejenige Seite des Topfkerns 46, aus welcher ein Magnetfeld 50, erzeugt durch die Spule 48, austritt, dem Maschinenelement 44 zugewandt ist.

Koaxial zu dem Topfkern 46 ist auf dessen, dem Maschinenelement 44 abgewandten Seite im Abstand zum Topfkern 46 ein zweiter, mit dem ersten Topfkern 46 identischer Topfkern 52 angeordnet, welcher eine Spule 54 trägt. Der Topfkern 52 ist ebenfalls derart im Gehäuse angeordnet, dass ein aus ihm austretendes Magnetfeld 56 in Richtung des ersten Topfkerns 46 weist. Zur Entkopplung der beiden Kerne 46 und 52 sowie der Spulen 48 und 54 ist zwischen diesen beiden Topfkernen eine Abschirmung 58 vorgesehen, die direkt auf der dem Topfkern 52 zugewandten Seite des Topfkerns 46 anliegt und im allgemeinen aus einem Metallblech besteht, welches denselben Durchmesser wie der Topfkern 46 besitzt.

Auf der dem Topfkern 46 abgewandten Seite des Topfkerns 52 ist in dem Gehäuse 42 eine elektrische Schaltung 60 vorgesehen. Diese umfasst, wie das Blockschaltbild in Fig. 5 zeigt, einen Oszillator 62 mit einem Schwingkreis, dessen Spule die Spule 48 darstellt. Die Spannungsamplitudenwerte des Oszillators 62 werden gemessen und in einem Gleichrichter 64 gleichgerichtet, der für eine Differenzschaltung 66 einen Signalpegel $P_1$ liefert, der proportional zu maximalen Spannungsamplitudenwerten des Oszillators 62 ist. Des weiteren umfasst die elektrische Schaltung 60 einen Oszillator 68 mit einem Schwingkreis, dessen Spule die Spule 54 darstellt. Auch bei diesem Oszillator werden die Spannungsamplitudenwerte gemessen, in einem Gleichrichter 70 gleichgerichtet und der Differenzschaltung 66 als Signalpegel $P_2$ zur Verfügung gestellt. Die Differenzschaltung 66 bildet nun das Differenzsignal $S_D$ aus diesen Signalen und leitet dieses einer Schaltung 72 zu, welche gegebenenfalls eine

Verstärkerschaltung, Frequenzfilter, eine Kippstufe für ein positives und eine Kippstufe für ein negatives Differenzsignal, gegebenenfalls ein Impulshalteglied sowie eine Leistungsendstufe umfasst, welche dann das Ausgangssignal A des Näherungsschalters liefert.

Wie in Fig. 4 dargestellt, liegt auch der Näherungsschalter 40 in einem Störfeld 76, welches durch ein stromführendes Kabel 74 erzeugt wird, das beispielsweise unterhalb des Näherungsschalters 40 verläuft. Dieses Störfeld durchdringt das Gehäuse 42 zumindest in Bereichen, welche die Topfkerne 46 und 52 umgeben.

Die Funktion des Näherungsschalters 40 wird zunächst ohne den Einfluss des Störfeldes 76 und ohne den Einfluss des Maschinenelementes 44 erläutert. In diesem Zustand schwingen beide Oszillatoren 62 und 68 des Näherungsschalters 40 mit ihrer jeweiligen Eigenfrequenz und es wird an beiden die maximale Spannungsamplitude gemessen, welche jeweils durch die Gleichrichter 64 und 70 in einen konstanten Signalpegel $P_1$ bzw. $P_2$ umgesetzt wird. Diese beiden Signalpegel $P_1$, $P_2$ können nun so gewählt werden, dass sie entweder gleich gross sind oder eine frei bestimmbare Differenz aufweisen. Das Differenzsignal $S_D$, gebildet durch die Differenzschaltung 66, ist entweder bei gleich grossen Signalpegeln $P_1$, $P_2$ Null oder zeigt einen konstanten Wert entsprechend dem vorherbestimmten Unterschied in den beiden Signalpegeln, der jedoch von der nachfolgenden Schaltung 72 als das Signal dafür erkannt wird, dass das Maschinenelement 44 nicht in seiner zu detektierenden Stellung ist, so dass am Ausgang der Schaltung 72 das dieser Stellung entsprechende Signal A anliegt.

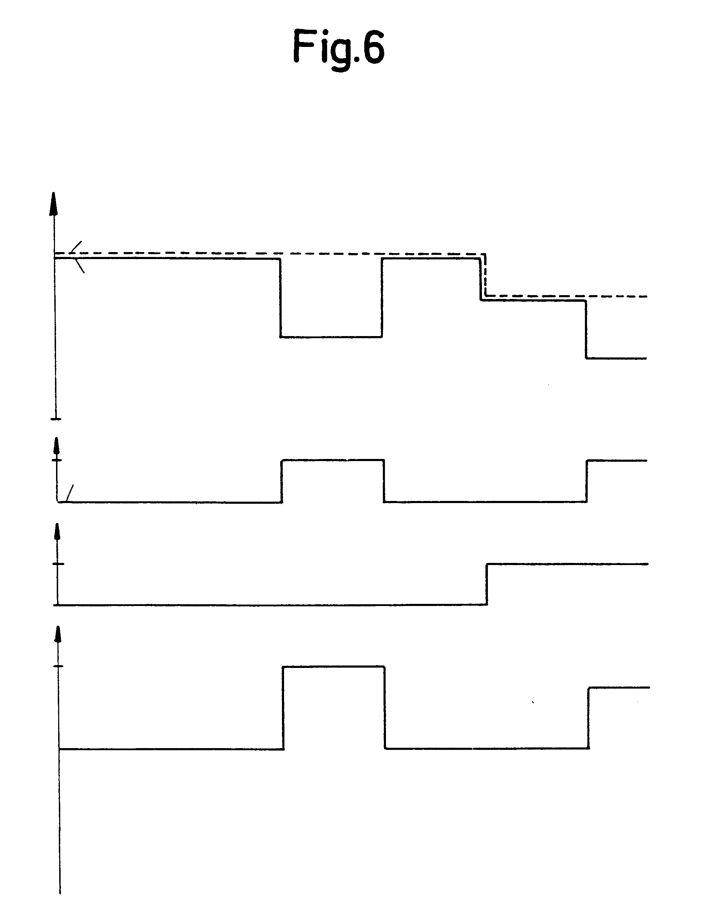

Sobald das Maschinenelement 44 seine zu detektierende Stellung erreicht, wird das Magnetfeld 50, ausgehend von dem Topfkern 46 und erzeugt von der Spule 48, gestört, so dass insgesamt eine Dämpfung des Oszillators 62, d.h. eine Verringerung der Spannungsamplitude eintritt (Fig.6). Folglich erzeugt der Gleichrichter 64 einen niedrigeren Signalpegel $P_1$, so dass sich das von der Differenzschaltung 66 gebildete Differenzsignal $S_D$ ändert und von der Schaltung 72 ein Ausgangssignal A erzeugt wird, welches der zu detektierenden Stellung des Maschinenelements 44 entspricht.

Wie bereits eingangs beschrieben, wirkt sich das Störfeld 76 so aus, dass beide Topfkerne 46 und 52 vormagnetisiert werden und somit in einem Bereich nahe ihrer Sättigung sind. Dadurch werden beide Oszillatoren 62 und 68 bedämpft, da die Wirkung des Ferrits der Topfkerne 46 und 52 aufgrund der Vormagnetisierung wesentlich geringer ist. Fig. 6 zeigt diese Bedämpfung der beiden Oszillatoren 62 und 68, wobei das Maschinenelement 44 nicht in seiner zu detektierenden Stellung ist und somit keinen Einfluss hat. Durch die Bedämpfung verringern sich auch die Spannungsamplituden der beiden Oszillatoren 62 und 68, so dass folglich auch die beiden von den Gleichrichtern 64 und 70 erzeugten Signalpegel $P_1$ und $P_2$ abnehmen. Das von der Differenzschaltung 66 erzeugte Differenzsignal $S_D$ ändert sich jedoch nicht, da die beiden Signalpegel $P_1$, $P_2$ in gleicher Weise abnehmen.

Erst durch das Maschinenelement 44 in seiner zu detektierenden Stellung ist eine Änderung des Differenzsignals $S_D$ erzeugbar, wobei ein Absolutwert des Differenzsignals $S_D$ aufgrund der Vormagnetisierung der Topfkerne 46, 52 kleiner ist als im störfeldfreien Fall (Fig. 6).

Bei Störfeldern 76, die einen Gradient in Richtung des Abstandes der Spulen 48 und 54 besitzen, wird der Abstand der Spulen 48 und 54 bevorzugterweise möglichst klein gewählt, damit das durch das Störfeld hervorgerufene Differenzsignal $S_D$ möglichst klein und folglich gegenüber dem durch das Maschinenelement hervorgerufenen Differenzsignal $S_D$ vernachlässigbar ist.

Sofern nicht durch das Störfeld 76 eine vollständige Bedämpfung der Oszillatoren 62 und 68 eintritt und sofern auch das Maschinenelement 44 den Oszillator 62 nicht sehr stark bedämpft, arbeitet der Magnetfeldsensor sowohl bei zeitlich konstanten wie auch bei zeitlich variablen Störfeldern einwandfrei.

Führt jedoch das Störfeld 76 zu einer nahezu vollständigen Bedämpfung beider Oszillatoren 62 und 68 und auch das Maschinenelement 44 in seiner zu detektierenden Stellung zu einer nahezu vollständigen Bedämpfung des Oszillators 62, so funktioniert der Näherungsschalter 40 zumindest bei zeitlich konstanten Störfeldern 76 nicht mehr, da der durch das Störfeld 76 nahezu vollständig bedämpfte Oszillator 62 die zusätzliche Bedämpfung durch das Maschinenelement 44 nicht mehr registriert. Im umgekehrten Fall, wenn der Oszillator 62 durch das Maschinenelement 44 in seiner zu detektierenden Stellung nahezu vollständig bedämpft ist, führt ein Störfeld 76, das ebenfalls den Oszillator 62 und den Oszillator 68 nahezu vollständig bedämpft, dazu, dass das Differenzsignal $S_D$ auf seinen Ausgangswert zurückgeht und nicht mehr den Wert aufweist, den es bei dem Maschinenelement 44 in seiner zu detektierenden Stellung normalerweise zeigen sollte. Diese Schwierigkeiten treten jedoch in einem normalerweise üblichen Anwendungsfall nicht auf, da in der Regel die Störfelder zeitabhängig sind. Beispielsweise wird beim Schweissen meist nur Wechselstrom verwendet, so dass auch die entsprechenden Störfelder dieselbe Zeitabhängigkeit wie der Wechselstrom besitzen. Damit werden auch die beiden Oszillatoren 62 und 68 mit derselben Frequenz wie das Störfeld bedämpft, so dass stets ein unbedämpfter Zustand mit einem bedämpften Zustand abwechselt. Dies kann dazu ausgenutzt werden, durch entsprechende elektronische Schaltungen die Differenz nur im störfeldfreien Zustand zu messen oder durch entsprechende Impulshalteglieder den kurzfristig sehr stark durch das Störfeld bedämpften Zustand für eine Messung zu eliminieren.

Eine weitere vorteilhafte Eigenschaft des erfindungsgemässen induktiven Näherungsschalters zeigt sich darin, dass die bisher bekannten Oszillatoren alle sehr starke Temperaturdriften aufweisen, so dass dadurch der Signalpegel $P_1$, ab welchem ein Maschinenelement 44 in seiner zu detektierenden Stellung angezeigt wird, mit sehr grossen Schwankungen behaftet ist. Daher konnte nur bei einer Bedämpfung des jeweiligen Oszillators, die grösser als die Schwankungen aufgrund der Temperaturdrift war, das Maschinenelement 44 in seiner zu detektierenden Stellung angezeigt werden, so dass diese notwendigerweise starke Dämpfung des jeweiligen Oszillators einen geringen Schaltabstand, d.h. einen geringen Abstand zwischen dem zu detektierenden Maschinenelement und der Spule für eine Auslösung eines Schaltsignals, erforderte. Mit dem zweiten Oszillator 68 als Referenz und der anschliessenden Differenzbildung können jedoch auch Temperaturschwankungen in erheblichem Masse ausgeglichen werden, so dass der erfindungsgemässe Näherungsschalter neben seiner Störfeldfestigkeit noch einen wesentlich grösseren Schaltabstand ermöglicht, da die temperaturbedingten Schwankungen der Spannungsamplitude des Oszillators 62 durch Vergleich mit der ebenfalls temperaturbedingten Schwankung der Spannungsamplitude des Oszillators 68 kompensiert werden können. Folglich reicht eine wesentlich geringere Bedämpfung des Oszillators 62 durch das Maschinenelement 44 aus, um zuverlässig das Schaltsignal, d.h. das Signal für das Maschinenelement 44 in seiner zu detektierenden Stellung, auszulösen, und somit kann auch der erforderliche Abstand zwischen dem Maschinenelement 44 und der Spule 48 oder dem Topfkern 46 zur Auslösung des Schaltsignals wesentlich grösser sein.

## Patentansprüche

1. Näherungsschalter zum Positionsnachweis eines Maschinenelements (24) mit mindestens zwei auf dieses Maschinenelement (24) ansprechenden und dabei ihre elektrischen Größen verändernden Sensoren (16, 18), die durch elektrische und/oder magnetische Störfelder (34) beeinflußbar sind, die in einem derartigen Abstand voneinander angeordnet sind, daß einer der Sensoren (16, 18) von dem Maschinenelement (24) in seiner zu detektierenden Stellung einen kleineren Abstand aufweist als der andere, und die zur Bildung eines Differenzsignals ($S_D$) aus den jeweiligen elektrischen Größen der Sensoren (16, 18) mit einer Differenzschaltung verbunden sind, um gleiche durch die Störfelder (34) erzeugte Signale zu kompensieren, **dadurch gekennzeichnet**, daß das Maschinenelement (24) mit einem Magnet (28) versehen ist, daß die Sensoren (16, 18) als auf den an dem Maschinenelement (24) gehaltenen Magneten (28) ansprechende Magnetfeldsensoren ausgebildet sind, daß zur Elimination von Störfeldern mit Störfeldgradienten die beiden Sensoren (16, 18) relativ zu dem Magnet (28) in der zu detektierenden Stellung des Maschinenelements (24) so in dem Magnetfeld (30) desselben angeordnet sind und einen derartigen Abstand voneinander besitzen, daß ein möglichst großer Feldgradient des Magneten (28) in Richtung des Abstandes der Sensoren (16, 18) vorliegt und der durch den Magneten (28) in seiner zu detektierenden Stellung erzeugte Anteil des Differenzsignals ($S_D$) größer ist als der durch die Störfelder (34) aufgrund ihres Störfeldgradienten erzeugte Anteil, und, daß der Näherungsschalter mit einem den Sensoren (16, 18) zugeordneten Schaltkreis (20) zum Umsetzen der veränderlichen elektrischen Größen der Sensoren (16, 18) in Ausgangssignale (A) des Näherungsschalters versehen ist, welcher das die zu detektierende Stellung des Maschinenelements anzeigende Ausgangssignal (A) nur bei Auftreten des durch den Magneten erzeugten Differenzsignals (50) abgibt.

2. Näherungsschalter nach Anspruch 1, dadurch gekennzeichnet, daß die beiden Sensoren (16, 18) relativ zu dem Maschinenelement (24) so angeordnet sind und einen derartigen Abstand voneinander besitzen, daß das aufgrund des Maschinenelements (24) in seiner zu detektierenden Stellung erzeugte Differenzsignal $(S_D)$ mindestens ungefähr um einen Faktor 10 größer ist als das durch die Störfelder (34) erzeugte Differenzsignal $(S_D)$.

3. Näherungsschalter nach Anspruch 1 oder 2, dadurch gekennzeichnet, daß die Magnetfeldsensoren (16, 18) jeweils eine Vorzugsrichtung (32) besitzen und so ausgerichtet sind, daß diese parallel zu einem nachzuweisenden Magnetfeld (30) verlaufen.

4. Näherungsschalter nach einem der voranstehenden Ansprüche, dadurch gekennzeichnet, daß die Magnetfeldsensoren (16, 18) aus einem Material hergestellt sind, das seinen elektrischen Widerstand in Abhängigkeit von dem äußeren Magnetfeld (30) ändert.

5. Näherungsschalter nach einem der voranstehenden Ansprüche, dadurch gekennzeichnet, daß die Sensoren (16, 18) Hallsensoren sind.

6. Näherungsschalter zum Positionsnachweis eines metallischen Maschinenelements (44) mit mindestens zwei als Spulen mindestens einer Oszillatorschaltung (62, 68) ausgebildeten und durch Annäherung des Maschinenelements (44) bedämpfbaren und dabei ihre elektrischen Größen verändernden Sensoren (48, 54), die durch magnetische Störfelder (76) beeinflußbar sind, die in einem derartigen Abstand voneinander angeordnet sind, daß einer der Sensoren (48, 54) von dem Maschinenelement (44) in seiner zu detektierenden Stellung einen kleineren Abstand aufweist als der andere, und die zur Erzeugung eines Differenzsignals $(S_D)$ aus den jeweiligen elektrischen Größen der Sensoren (48, 54) miteinander verbunden sind, um die durch die Störfelder (76) erzeugten Signale zu kompensieren, und mit einem den Sensoren (48, 54) zugeordneten Schaltkreis (60) zum Umsetzen des Differenzsignals $(S_D)$ in Ausgangssignale (A) des Näherungsschalters, dadurch gekennzeichnet, daß jeder Spule (48, 54) ein eigener Oszillator (62, 68) und jeder Spule (48, 54) mit eigenem Oszillator (62, 68) eine eigene Gleichrichterschaltung (64, 70) zugeordnet ist, welch letztere an dem zugeordneten Oszillator (62, 68) abgegriffene Spannungen gleichrichtet und einen Mittelwert $(P_1, P_2)$ bildet sowie diesen Mittelwert einer Differenzschaltung (66) zur Erzeugung des Differenzsignals $(S_D)$ übermittelt, und daß die beiden Sensoren (48, 54) relativ zu dem Maschinenelement (44) so angeordnet sind und einen derartigen Abstand voneinander besitzen, daß ein möglichst großer Gradient der durch das Maschinenelement hervorgerufenen Bedämpfung in Richtung des Abstandes der Sensoren (48, 54) vorliegt und der aufgrund des Maschinenelements (44) in seiner zu detektierenden Stellung erzeugte Anteil des Differenzsignals $(S_D)$ größer ist als der durch die Störfelder (76) aufgrund ihres Störfeldgradienten erzeugte Anteil, und daß der Näherungsschalter mit einem den Sensoren (48, 54) zugeordneten Schaltkreis (66, 72) zum Umsetzen der veränderlichen elektrischen Größen der Sensoren (48, 54) in Ausgangssignale (A) des Näherungsschalters versehen ist, welcher das die zu detektierende Stellung des Maschinenelements (44) anzeigende Ausgangssignal (A) nur bei Auftreten des durch das Maschinenelement (44) erzeugten Differenzsignals $(S_D)$ abgibt.

7. Näherungsschalter nach Anspruch 6, dadurch gekennzeichnet, daß die beiden Sensoren (48, 54) relativ zu dem Maschinenelement (44) so angeordnet sind und einen derartigen Abstand voneinander besitzen, daß das aufgrund des Maschinenelements (44) in seiner zu detektierenden Stellung erzeugte Differenzsignal $(S_D)$ mindestens ungefähr um einen Faktor 10 größer ist als das durch die Störfelder (76) erzeugte Differenzsignal $(S_D)$.

8. Näherungsschalter nach Anspruch 6 oder 7, dadurch gekennzeichnet, daß die Spulen(48, 54) mit Topfkernen (46, 52) versehen sind.

9. Näherungsschalter nach einem der Ansprüche 6 bis 8, dadurch gekennzeichnet, daß zwischen den Spulen (48, 54) eine Abschirmung (58) vorgesehen ist.

10. Näherungsschalter nach einem der Ansprüche 6 bis 9, dadurch gekennzeichnet, daß die Spulen (48, 54) identisch ausgebildet sind.

11. Näherungsschalter nach einem der Ansprüche 6 bis 10, dadurch gekennzeichnet, daß die Spulen (48, 54) koaxial zueinander angeordnet sind.

## Claims

1. Proximity switch for detecting the position of a machine element (24) having at least two sensors (16, 18), which respond to this machine element (24) and then alter their electrical variables and which may be influenced by electrical and/or magnetic interference fields (34) and which are arranged at a spacing from one another such that one of the sensors (16, 18) has a smaller spacing from the machine element (24) in its position to be detected than the other, and these sensors are connected, for forming a difference signal ($S_D$) from the respective electrical variables of the sensors (16, 18), to a difference circuit in order to compensate like signals generated by the interference fields (34), characterized in that the machine element (24) is provided with a magnet (28), in that the sensors (16, 18) are constructed as magnetic field sensors responding to the magnet (28) held on the machine element (24), in that to eliminate interference fields with interference field gradients the two sensors (16, 18) are arranged relative to the magnet (28), in the position of the machine element (24) to be detected, in the magnetic field (30) thereof in such a way and have such a spacing from one another that there is as large as possible a field gradient of the magnet (28) in the direction of the spacing of the sensors (16, 18) and the portion of the difference signal ($S_D$) generated by the magnet (28) in its position to be detected is greater than the portion generated by the interference fields (34) on the basis of their interference field gradient, and in that the proximity switch is provided with a circuit (20) associated with the sensors (16, 18) for converting the changeable electrical variables of the sensors (16, 18) into output signals (A) of the proximity switch, which emits the output signal (A) indicating the position of the machine element to be detected only on the occurrence of the difference signal (50) generated by the magnet.

2. Proximity switch according to Claim 1, characterized in that the two sensors (16, 18) are arranged relative to the machine element (24) in such a way and have such a spacing from one another that the difference signal ($S_D$) generated on the basis of the machine element (24) in its position to be detected is greater at least approximately by a factor of 10 than the difference signal ($S_D$) generated by the interference fields (34).

3. Proximity switch according to Claim 1 or 2, characterized in that the magnetic field sensors (16, 18) each have a preferred direction (32) and are aligned such that these run parallel to a magnetic field (30) to be detected.

4. Proximity switch according to one of the preceding claims, characterized in that the magnetic field sensors (16, 18) are produced from a material which alters its electrical resistance as a function of the external magnetic field (30).

5. Proximity switch according to one of the preceding claims, characterized in that the sensors (16, 18) are Hall-effect sensors.

6. Proximity switch for detecting the position of a metal machine element (44) having at least two sensors (48, 54), which are constructed as coils of at least one oscillator circuit (62, 68) and which are dampable by the approach of the machine element (44) and then alter their electrical variables and which may be influenced by magnetic interference fields (76) and which are arranged at a spacing from one another such that one of the sensors (48, 54) has a smaller spacing from the machine element (44) in its position to be detected than the other, and which, to generate a difference signal ($S_D$) from the respective electrical variables of the sensors (48, 54), are connected to one another in order to compensate the signals generated by the interference fields (76), and having a circuit (60) associated with the sensors (48, 54) for converting the difference signal ($S_D$) into output signals (A) of the proximity switch, characterized in that each coil (48, 54) has associated with it its own oscillator (62, 68), and each coil (48, 54) having its own oscillator (62, 68) has associated with it its own rectifier circuit (64, 70), the latter rectifying voltages picked off at the associated oscillator (62, 68) and forming an average value ($P_1$, $P_2$) and conveying this average value to a difference circuit (66) to generate the difference signal ($S_D$), and in that the two sensors (48, 54) are arranged relative to the machine element (44) in such a way and have such a spacing from one another that there is as large as possible a gradient of the damping produced by the machine element in the direction of the spacing of the sensors (48, 54), and the portion, generated on the basis of the machine element (44) in its position to be detected, of the difference signal ($S_D$) is greater than the portion generated by the interference fields (76) on the basis of their interference field gradient, and in that the proximity switch is provided with a circuit (66, 72) associated with the sensors (48, 54) for converting the changeable electrical variables of the sensors (48, 54) into output signals (A) of the proximity switch, which emits the output signal (A) indicating the position of the machine element (44) to be detected only on the occurrence of the difference signal ($S_D$) generated by the machine element (44).

7. Proximity switch according to Claim 6, characterized in that the two sensors (48, 54) are arranged relative to the machine element (44) in such a way and have such a spacing from one another that the difference signal ($S_D$) generated on the basis of the machine element (44) in its position to be detected is greater at least approximately by a factor of 10 than the difference signal ($S_D$) generated by the interference fields (76).

8. Proximity switch according to Claim 6 or 7, characterized in that the coils (48, 54) are provided with cup-type cores (46, 52).

9. Proximity switch according to one of Claims 6 to 8, characterized in that a screen (58) is provided between the coils (48, 54).

10. Proximity switch according to one of Claims 6 to 9, characterized in that the coils (48, 54) are of identical construction.

11. Proximity switch according to one of Claims 6 to 10, characterized in that the coils (48, 54) are arranged coaxially to one another.

**Revendications**

1. Commutateur de proximité pour identification de position d'un élément de machine (24), comportant au moins deux détecteurs (16, 18) qui réagissent à cet élément de machine (24) en modifiant alors leurs signaux électriques et qui peuvent être influencés par des champs parasites électriques et/ou magnétiques (34), ces détecteurs étant écartés l'un de l'autre d'une distance telle qu'un des détecteurs (16, 18) soit espacé de l'élément de machine (24), dans sa position de détection, d'une plus petite distance que l'autre et étant reliés, pour la génération d'un signal ($S_D$) représentant la différence des signaux électriques correspondants des détecteurs (16, 18), à un circuit de détermination de différence de façon à compenser des signaux identiques produits par les champs parasites (34), caractérisé en ce que l'élément de machine (24) est pourvu d'un aimant (28), en ce que les détecteurs (16, 18) sont agencés comme des détecteurs de champ magnétique réagissant à l'aimant (28) maintenu sur l'élément de machine (24), en ce que, pour éliminer des champs parasites ayant des gradients, les deux détecteurs (16, 18) sont disposés par rapport à l'aimant (28), dans la position de détection de l'élément de machine (24), dans le champ magnétique (30) de ce dernier et sont espacés l'un de l'autre d'une distance telle qu'un gradient de champ aussi grand que possible de l'aimant (28) soit produit dans la direction d'espacement des détecteurs (16, 18) et que la partie du signal de différence ($S_D$) qui est produite par l'aimant (28) dans sa position de détection soit plus grande que la partie produite par les champs parasites (34) sous l'effet de leur gradient, en ce que le commutateur de proximité est pourvu d'un circuit de commande (20) associé aux détecteurs (16, 18) et servant à convertir les données électriques variables des détecteurs (16, 18) en signaux de sortie (A) du commutateur de proximité, qui produit à sa sortie le signal (A) indiquant la position de détection de l'élément de machine seulement lors de la génération du signal de différence (50) engendré par l'aimant.

2. Commutateur de proximité selon la revendication 1, caractérisé en ce que les deux détecteurs (16, 18) sont disposés par rapport à l'élément de machine (24) et sont espacés l'un de l'autre d'une distance telle que le signal de différence ($S_D$), produit sous l'effet de l'élément de machine (24) dans sa position de détection est plus grand, d'au moins approximativement un facteur 10 , que le signal de différence ($S_D$) produit par les champs parasites (34).

3. Commutateur de proximité selon la revendication 1 ou 2, caractérisé en ce que les détecteurs de champ magnétique (16, 18) comportent respectivement une direction préférentielle (32) et sont agencés de telle sorte que celles-ci sont orientées parallèlement à un champ magnétique (30) à identifier.

4. Commutateur de proximité selon l'une des revendications précédentes, caractérisé en ce que les détecteurs de champ magnétique (16, 18) sont fabriqués en un matériau dont la résistance électrique varie en fonction du champ magnétique extérieur (30).

5. Commutateur de proximité selon l'une des revendications précédentes, caractérisé en ce que les détecteurs (16, 18) sont des détecteurs de Hall.

6. Commutateur de proximité pour identification de position d'un élément métallique de machine (44), comportant au moins deux détecteurs (48, 54), réalisés comme des bobines d'au moins un circuit oscillateur (62, 68), pouvant être amortis par rapprochement de l'élément de machine (44) et modifiant alors leurs données électriques, lesdits détecteurs pouvant être influencés par des champs parasites magnétiques (76), étant écartés l'un de l'autre d'une distance telle qu'un des détecteurs (48, 54) soit espacé de l'élément de machine (44), dans sa position de détection, d'une plus petite distance que l'autre, et étant reliés entre eux, pour la production d'un signal de différence (S$_D$) à partir des signaux électriques correspondants des détecteurs (48, 54), de façon à compenser les signaux produits par les champs parasites (76), le commutateur de proximité étant pourvu d'un circuit de commande (60), associé aux détecteurs (48, 54), pour convertir le signal de différence (S$_D$) en signaux (A) de sortie du commutateur de proximité, caractérisé en ce qu'à chaque bobine (48, 54) est associé un oscillateur propre (62, 68) et à chaque bobine (48, 54) pourvue d'un oscillateur propre (62, 68) est associé un circuit redresseur propre (64, 70), ce dernier redressant les tensions prises à l'oscillateur associé (62, 68) et produisant une valeur moyenne (P$_1$, P$_2$) qui est transmise à un circuit de détermination de différence (66) servant à produire le signal de différence (S$_D$), et en ce que les deux détecteurs (48, 54) sont disposés par rapport à l'élément de machine (44) et sont espacés l'un de l'autre de telle façon qu'un gradient aussi grand que possible de l'amortissement engendré par l'élément de machine soit produit dans la direction d'espacement des détecteurs (48, 54) et que la partie du signal de différence (S$_D$) qui est produite sous l'effet de l'élément de machine (44) dans sa position de détection soit plus grande que la partie produite par les champs parasites (76) sous l'effet de leurs gradients, et en ce que le commutateur de proximité est pourvu d'un circuit de commande (68, 72), associé aux détecteurs (48, 54), pour convertir les signaux électriques variables des détecteurs (48, 54) en signaux de sortie (A) du commutateur de proximité, qui produit le signal de sortie (A), indiquant la position de détection de l'élément de machine (44), seulement lors de l'apparition du signal de différence (S$_D$) produit par l'élément de machine (44).

7. Commutateur de proximité selon la revendication 6, caractérisé en ce que les deux détecteurs (48, 54) sont disposés par rapport à l'élément de machine (44) et sont espacés l'un de l'autre d'une distance telle que le signal de différence (S$_D$), produit sous l'effet de l'élément de machine (44) dans sa position de détection, est plus grand, au moins approximativement d'un facteur 10, que le signal de différence (S$_D$) produit par les champs parasites (76).

8. Commutateur de proximité selon la revendication 6 ou 7, caractérisé en ce que les bobines (48, 54) sont pourvues de noyaux en forme de pots (46, 52).

9. Commutateur de proximité selon l'une des revendications 6 à 8, caractérisé en ce qu'il est prévu un écran (58) entre les bobines (48,54).

10. Commutateur de proximité selon l'une des revendications 6 à 9, caractérisé en ce que les bobines (48, 54) sont réalisées de façon identique.

11. Commutateur de proximité selon l'une des revendications 6 à 10, caractérisé en ce que les bobines (48, 54) sont disposées mutuellement coaxialement.

# Fig.1

# Fig.2

# Fig.3

28  32

30  16  18  34  36

# Fig.4

# Fig.5

# Fig.6